## Europäisches Patentamt
## European Patent Office
## Office européen des brevets

(19)

(11) Numéro de publication: **0 037 749**
A1

(12) # DEMANDE DE BREVET EUROPEEN

(21) Numéro de dépôt: 81400315.8

(22) Date de dépôt: 27.02.81

(51) Int. Cl.³: **H 05 K 3/36**

(30) Priorité: 25.03.80 FR 8006612

(43) Date de publication de la demande:
14.10.81 Bulletin 81/41

(84) Etats contractants désignés:
**DE GB NL**

(71) Demandeur: THOMSON-CSF
173, Boulevard Haussmann
F-75360 Paris Cedex 08(FR)

(72) Inventeur: Legrand, Pierre
THOMSON-CSF SCPI 173, bld Haussmann
F-75360 Paris Cedex 08(FR)

(72) Inventeur: Desperques-Volmier, Serge
THOMSON-CSF SCPI 173, bld Haussmann
F-75360 Paris Cedex 08(FR)

(72) Inventeur: Baylard, Marcel
THOMSON-CSF SCPI 173, bld Haussmann
F-75360 Paris Cedex 08(FR)

(74) Mandataire: Giraud, Pierre et al,
"THOMSON-CSF" - SCPI 173, bld Haussmann
F-75360 Paris Cedex 08(FR)

(54) **Support de composant électronique pour carte de câblage.**

(57) L'invention a pour but de fournir un moyen de raccorder de façon simple, rapide et sans erreur de branchement, des composants enfichés sur une carte de câblage, avec des équipements de test et/ou de mesure.

Le support est constitué, à cet effet, par une plaque (9) en matériau isolant, du type utilisé pour réaliser les circuits imprimés, et présente des trous métallisés (91, 92) munis de douilles élastiques (90). Le composant (4) est enfiché dans des douilles (31) prolongées par des appendices de connexion (32) traversant la carte de câblage. Les douilles (90) destinées aux fiches des équipements de test et/ou de mesure sont reliées aux douilles (31) par des métallisations (93) tapissant les bords des trous métallisés.

Application aux cartes de circuits intégrés.

FIG.3

EP 0 037 749 A1

## SUPPORT DE COMPOSANT ELECTRONIQUE POUR CARTE DE CABLAGE

L'invention concerne un support de composant électronique pour carte de câblage, notamment pour les circuits intégrés.

On sait qu'entre les composants du type "circuit intégré" et le reste de l'équipement d'une machine électronique ou électro-mécanique, on installe habituellement des interfaces, appelées souvent carte de câblage, comportant, sur une première face, des moyens de montage de composants électroniques, notamment de circuits intégrés, et, sur une deuxième face opposée à la première, des câblages imprimés et des moyens d'accès aux connexions des composants et/ou circuits montés sur la première face en traversant de part en part la carte de câblage. Certains composants sont enfichés directement sur la carte de câblage, celle-ci comportant alors des douilles élastiques d'enfichage. En ce qui concerne les circuits intégrés, ils sont fréquemment montés par l'intermédiaire de supports établissant les contacts nécessaires entre les sorties du circuit intégré et les broches équipant le support et permettant d'enficher l'ensemble sur la carte de câblage.

De tels supports intermédiaires présentent des avantages, car ils facilitent les opérations de montage en les décomposant en étapes séparées, ce qui préserve les circuits intégrés d'accidents d'ordre mécanique pendant les manipulations dues aux opérations de fabrication de la carte de câblage. Toutefois ils présentent des défauts, d'ailleurs inhérents au système de la

2

carte de câblage. En effet, lorsqu'on veut vérifier le fonctionnement des composants montés sur la carte, on doit brancher un ou plusieurs appareils de mesure en différents points de l'équipement.

Si l'on prend le contact du côté des connexions, il est difficile d'identifier le point à brancher car les circuits intégrés ne sont pas visibles sur cette face de la carte, et, d'autre part, dans le cas d'une connexion soudée à une broche traversant la carte, il est difficile de fixer, de façon stable la prise de mesure sur la connexion ;

Si l'on prend le contact du côté des composants, on utilise soit des pinces du type à un seul contact (genre pince crocodile) soit des pinces à deux prises de contact isolées l'une de l'autre ou encore dans le cas des circuits intégrés, des pinces présentant autant de contacts isolés qu'il y a de sorties du circuit. Mais cette technique s'est révélée nuisible à la fiabilité des circuits intégrés en raison des fortes contraintes mécaniques exercées sur le boîtier qu'elle peut faire sortir partiellement ou totalement de son support.

L'invention tend à éviter ces inconvénients, en permettant de connecter facilement, sans erreur possible, les prises des équipements de mesure.

Le support selon l'invention est du type servant d'intermédiaire entre un composant électronique et une carte de câblage. Il comporte des douilles destinées à l'enfichage du composant sur le support, douilles que l'on appellera "de première catégorie".

Il est caractérisé principalement en ce qu'il comporte en outre des douilles de deuxième catégorie dont chacune est reliée électriquement à une douille de première catégorie, les douilles de deuxième catégorie étant destinées à servir de prises de mesure.

Selon une autre caractéristique de l'invention,

3

le support comporte des trous métallisés, chacun étant relié par une métallisation du type "câblage imprimé" à une douille de première catégorie, chaque trou métallisé comportant une douille de deuxième catégorie.

L'invention sera mieux comprise, et d'autres caractéristiques apparaîtront, au moyen de la description qui suit, et des dessins qui l'accompagnent, parmi lesquels :

Les figures 1 et 2 sont relatives à l'art connu ;

La figure 3 représente en coupe schématique un support selon l'invention ainsi qu'un composant placé sur le support, et un fragment de la carte de câblage où le support est enfiché ;

La figure 4 représente, vu par dessous, un support de circuit intégré selon l'invention.

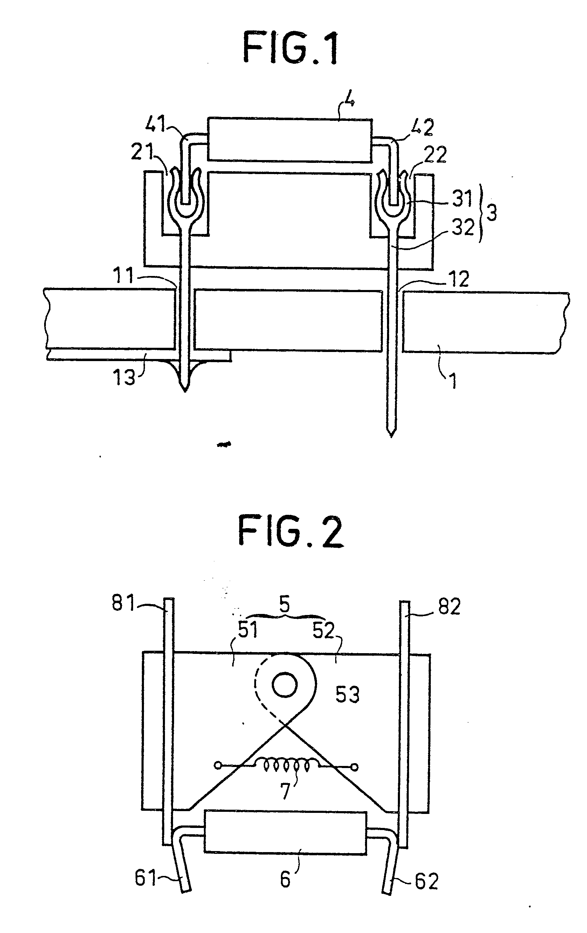

Sur la figure 1, on a représenté en coupe partielle une carte de câblage en matériau isolant, comportant des perforations 11, 12. Un support 2 comporte des alvéoles 21, 22 où sont logées des pièces métalliques 3 constituées par des douilles élastiques 31 prolongées, par exemple, par des broches 32 traversant le support par le fond de l'alvéole. On a représenté schématiquement le support 2 enfiché par les broches 32 dans les perforations de la carte de câblage. Il est bien entendu que, dans le cas d'un circuit intégré le support comporte généralement deux séries d'alvéoles 21 et 22 et les douilles élastiques correspondantes, alignées suivant des droites perpendiculaires au plan de coupe de la figure 1.

Certaines broches sont soudées à des métallisations 13 déposées sur la face de la carte opposée aux composants. C'est le cas de la connexion 11. La connexion 12, plus longue, est destinée à recevoir une connexion enroulée.

Le schéma de la figure 1 est complété par le des-

4

sin d'un composant 4 dont les connexions 41 et 42 sont enfichées dans des douilles 31.

Sur la figure 2, on a représenté en coupe schématique une pince de mesure du type déjà évoqué. Cette pince 5 comporte deux pièces électriquement isolantes 51 et 52 pouvant pivoter autour d'un axe 53 et fortement sollicitées par un ressort 7 dans un sens tel qu'elle serre fortement des pièces conductrices 81 et 82 insérées dans les pièces 51 et 52 de manière à prendre contact avec les sorties 61 et 62 du circuit intégré 6. Il est bien entendu que, dans le cas de l'invention, il est inutile de recourir à une telle pince.

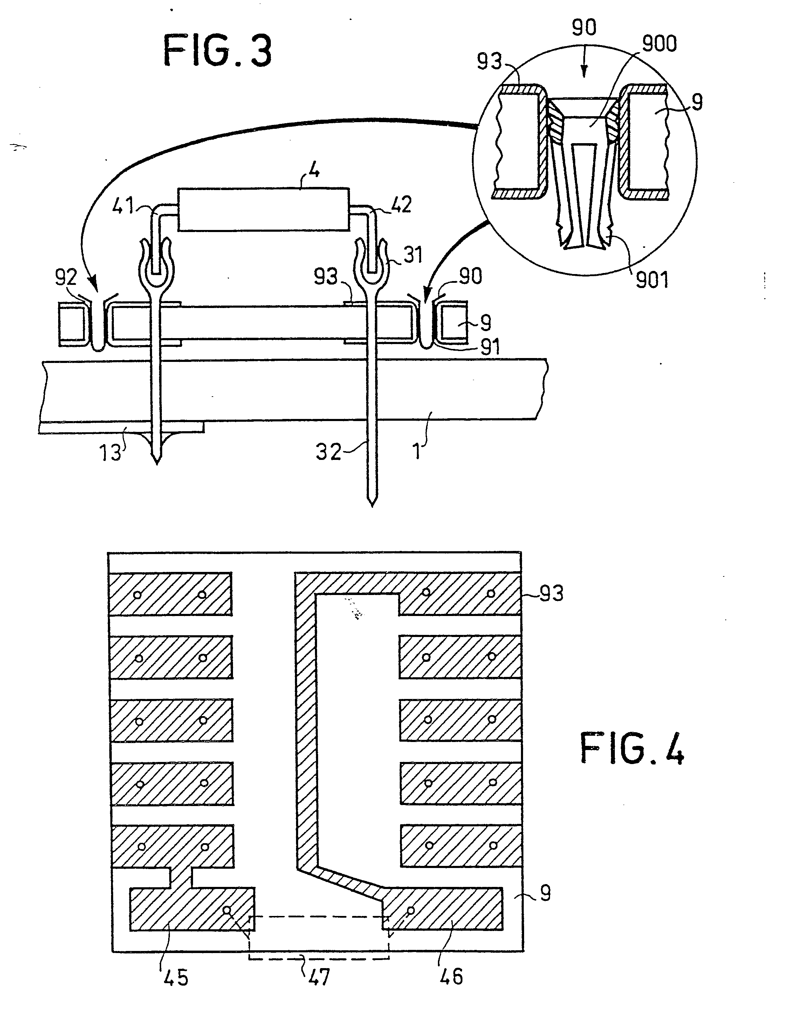

Sur la figure 3, on a représenté un fragment de carte de câblage, les mêmes repères désignant les mêmes éléments. A titre d'exemple non limitatif, le support selon l'invention est une carte du type "circuit imprimé" constituée par une plaque isolante revêtue de chemins conducteurs constitués par des dépôts métalliques et présentant des perforations dont certaines sont revêtues de dépôts métalliques, constituant ainsi des trous métallisés. Dans la réalisation donnée à titre d'exemple à la figure 3, les trous métallisés 91 et 92 sont munis de douilles élastiques 90 ; on a représenté en médaillon une coupe d'un trou métallisé équipé d'une douille. Une telle douille, de type classique, comporte un corps cylindrique à entrée tronconique 900, muni de quatre pattes élastiques 901 dont la face interne présente une concavité de forme cylindrique en vue d'établir un bon contact électrique entre la douille, réalisée en métal conducteur, et une fiche d'appareil de mesure (non représentée). La douille 90 est immobilisée dans le trou métallisé par un bourrelet 902 en matériau plastique, ou éventuellement par un cordon de soudure ou de colle.

5

Sur la face du support où sont enfichés les composants, il existe des dépôts métalliques 93 reliant électriquement les pièces 32 et les trous métallisés 9 dont elles tapissent les bords et les parois.

Dans une variante de l'invention, la douille 31 et la connexion 32 sont deux pièces distinctes. La partie supérieure de la pièce 32 comporte une partie cylindrique creuse pouvant servir de logement à la douille 31. Eventuellement, la plaque 9 est assez épaisse pour que la douille 31 et son logement soient enfoncés dans le support, de telle sorte qu'ils affleurent à la surface de celui-ci.

Sur la figure 4, on a représenté un support 9, vu par dessous, ce qui fait apparaître les métallisations 93. Deux d'entre elles comportent des câblages imprimés aboutissant à des plages métallisées 45 et 46. Entre ces plages on peut connecter une capacité de découplage 47 (représentée en pointillé) ce qui peut être utile par exemple dans le cas des connexions d'alimentation du circuit intégré.

Parmi les avantages de l'invention, on doit mentionner la grande souplesse du procédé consistant à interposer un support entre circuit intégré et carte de câblage. En effet, en cas de changement de type de circuit intégré, on peut conserver la même carte en changeant seulement le support. L'adaptation d'un nouveau support sur une carte existante, même en cas de changement de nombre et de disposition des sorties du circuit intégré, est facile car elle n'exige la plupart du temps que quelques perforations supplémentaires de la carte de câblage.

6

REVENDICATIONS

1. Support destiné à servir d'intermédiaire entre un composant électronique et une carte de câblage, du type comportant une première catégorie de douilles destinées à l'enfichage de composants sur le support, caractérisé en ce qu'il comporte en outre une deuxième catégorie de douilles dont chacune est reliée électriquement à une douille de la première catégorie, les douilles de la deuxième catégorie étant destinées à servir de prise de mesure.

2. Support selon la revendication 1, caractérisé en ce qu'il comporte des trous métallisés équipés de douilles de la deuxième catégorie, chaque trou métallisé étant relié à un plage de métallisation entourant une douille de la première catégorie.

3. Support selon la revendication 2, caractérisé en ce que chaque douille de la première catégorie est en contact mécanique et électrique avec une broche de connexion destinée à être reliée aux connexions situées sur la face de la carte de câblage opposée au support, en utilisant des perforations de la carte de câblage.

4. Support selon la revendication 3, caractérisé en ce qu'il comporte des câblages imprimés raccordés aux plages de métallisation entourant les douilles de première et de deuxième catégories.

5. Support selon l'une quelconque des revendications 1 à 4, caractérisé en ce qu'il est adapté au brochage d'un circuit intégré.

# FIG.1

# FIG.2

# FIG.3

# FIG.4

**0037749**

Numéro de la demande

**RAPPORT DE RECHERCHE EUROPEENNE**

Office européen
des brevets

EP 81 40 0315

| Catégorie | Citation du document avec indication, en cas de besoin, des parties pertinentes | Revendication concernée | CLASSEMENT DE LA DEMANDE (Int. Cl.³) |
|---|---|---|---|
| | **DOCUMENTS CONSIDERES COMME PERTINENTS** | | |
| A | GB - A - 2 050 067 (INTERCONNECTION TECHNOLOGY INC.) <br> * Revendications; figures 1-8 * | 1-5 | H 05 K 3/36 |
| A | US - A. - 4 084 869 (INTEL CORP.) <br> * Revendications; figures 1-5 * | 1 | |

**DOMAINES TECHNIQUES RECHERCHES (Int. Cl.³)**

H 05 K   3/36
  3/00
  13/08

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 13-07-1981 | VAN REETH |

OEB Form 1503.1   06.78